# EUROPEAN PATENT APPLICATION

(11) **EP 4 456 679 A1**
(43) Date of publication of application: **30.10.2024**
(21) Application number: 23169606.3
(22) Date of filing: 24.04.2023
(51) Int. Cl.: H05K 3/28, H05K 3/22

(54) **RECYCLABLE ELECTRONIC DEVICE, AND METHOD AND APPARATUS FOR MANUFACTURING AND RECYCLING THE DEVICE**

(71) Applicant: Nederlandse Organisatie voor toegepast-natuurwetenschappelijk Onderzoek TNO, 2595 DA 's-Gravenhage (NL)
(72) Inventor: HARKEMA, Stephan, 2595 DA 's-Gravenhage (NL); RENTROP, Cornelis Hermanus Arnoldus, 2595 DA 's-Gravenhage (NL)
(74) Representative: V.O.

(57) **Abstract**

An electronic device comprising a stack with a circuit layer (15) covered by at least one delamination layer (12). A graphic layer (13) with a pattern of one or more light reflecting areas (13f) and one or more light absorbing areas (13s) is provided at a first side (S1). The one or more light reflecting areas (13f) are arranged to cover circuit parts (15c) of the circuit layer (15). The one or more light absorbing areas (13s) are arranged at areas without the circuit parts (15c) and without the at least one delamination layer (12), and are configured to delaminate under the influence of light transmitted through a first substrate (11) and absorbed by the one or more light absorbing areas (13s), while the one or more light reflecting areas (13f) are configured to reflect said light.

## Description

### TECHNICAL FIELD AND BACKGROUND

The present disclosure relates to electronic devices and methods of manufacturing and recycling such devices.

Recycling in electronics (e.g. in automotive) is a challenge for the printed electronics (PE) community. Although the PE technology is foreseen as much greener than the printed circuit board (PCB) alternative, the high level of integration makes it very hard to dismantle electronics from the original product, thus disturbing the current recycling cycle. For example, electronics recycling now occurs at PCB level as the package surrounding the PCB is easily removed. In the future electronics will become a part of the complete product (e.g. in structural electronics and 3D printed electronics). At present, PCB boards are grinded to powder, instead of being properly recycled for re-usage. The foil based alternative in PE is therefore already a big step forward.

WO2022/220688 describes manufacturing methods for producing an electronic device that is more easily recyclable, by applying one or more delamination layers to one or both sides of the electronics. By providing select passages through the delamination layer, a limited set of connections can be established to prevent inadvertent delamination of the substrate during normal use, while being weak enough to allow breaking apart during a later recycling process.

There is yet a desire for further improvements of electronic devices and methods of manufacturing and recycling, such as further improvements of reliability and durability, as well as maintaining advantages of recyclability.

### SUMMARY

Aspects of the present disclosure relate to an electronic device comprising a stack (10) comprising a first substrate, provided on a first side of the stack, a second substrate, provided on a second side of the stack opposite the first side, and a circuit layer comprising circuit parts disposed between the first substrate and the second substrate, wherein the second substrate is shaped to encapsulate the circuit layer between the second substrate and the first substrate. The stack comprises at least one delamination layer covering a side of the circuit layer facing the second substrate and configured to separate the circuit parts from the second substrate, wherein the at least one delamination layer forms an adhesive connection between the circuit layer and the second substrate with a first adhesive strength. The stack comprises a graphic layer disposed between the circuit layer and the first substrate, wherein the graphic layer comprises a pattern of one or more light reflecting areas and one or more light absorbing areas. The one or more light reflecting areas are arranged to cover the circuit parts at the first side, wherein the one or more light absorbing areas are arranged at areas without the circuit parts and without the at least one delamination layer, forming an adhesive connection between the first substrate and the second substrate with a second adhesive strength higher than the first adhesive strength of the at least one delamination layer. The one or more light absorbing areas are configured to delaminate under the influence of light transmitted through the first substrate and absorbed by the one or more light absorbing areas, while the one or more light reflecting areas are configured to reflect said light.

By the graphic layer forming an adhesive connection between the first substrate and the second substrate with a second adhesive strength higher than the first adhesive strength of the at least one delamination layer, the reliability and durability of the electronic device is improved.

At the same time, the recyclability of the device is maintained by providing a pattern of one or more light absorbing areas and light reflecting areas in the graphic layer. By having the one or more light absorbing areas configured to delaminate under the influence of light transmitted through the first substrate and absorbed by the one or more light absorbing areas, the light absorbing areas thus acting as a photonically activated delamination layer, the connection between the first and second substrate can be broken, while the circuit parts in the circuit layer are protected against photonic energy and/or generated heat by the one or more light reflecting areas of the graphic layer.

Also, by the graphic layer comprising a pattern of one or more light reflecting areas and light absorbing areas, the steps of separating the first and second substrate, and separating the circuit layer and the first substrate, can be split up. As such, it can be prevented that the circuit parts are delaminated from the first substrate by photonic debonding, so that the step of separating the circuit parts from the first substrate can be performed in a later stage of the recycling process.

The light is thus passed through the first substrate, absorbed by the one or more light absorbing areas, and reflected by the one or more light reflecting areas, and can e.g. be one or more of visible light, ultra-violet (UV) light, or infrared (IR) light. For example, in the visible light spectrum, the light can have a wavelength ranging between 200-1100 nanometer, corresponding to frequencies of 750-420 terahertz, preferably a wavelength ranging between 400-700 nanometer, corresponding to frequencies of 430 terahertz to 750 terahertz. For example, in the UV spectrum, the light can have a wavelength ranging between 10-400 nanometer, corresponding to frequencies of 750 terahertz to 30 picohertz. For example, in the IR spectrum, the light can have a wavelength ranging between 700 nanometer and 1 mm, corresponding to frequencies of 300 gigahertz to 430 terahertz.

In some embodiments, the one or more light absorbing areas absorb more than the light reflecting areas in the said wavelength ranges, e.g. more than a factor two, three, five, ten, or more. In other or further embodiments, the one or more light reflecting areas reflect more than the one or more light absorbing areas in the said wavelength ranges, e.g. more than a factor two, three, five, ten, or more. Preferably, the one or more light absorbing areas are configured to absorb at least 50% of the light in the said wavelength ranges that is incident on the one or more light absorbing areas, instead of light being reflected or refracted. More preferably, the one or more light absorbing areas are configured to absorb at least 90%, most preferably at least 99% of the incident light in the said wavelength ranges.

Conversely, the one or more light reflecting areas are preferably configured to reflect at least 50% of the light in the said wavelength ranges that is incident on the one or more light reflecting areas, instead of light being absorbed or refracted. More preferably, the one or more light reflecting areas are configured to reflect at least 90%, most preferably at least 99% of the incident light in the said wavelength ranges.

In some embodiments, the second substrate comprises an injection molded encapsulation layer. This may improve bonding between the circuit layer and the second substrate. Suitable materials may e.g. include polycarbonate (PC), polyamide (PA), polyether ether ketone (PEEK), high-density polyethylene (HDPE), and/ or polyethylene terephthalate (PET). Also other or further materials can be used such as Acrylonitrile Butadiene Styrene (ABS), polyethylene (PE), polypropylene (PP), and/or polystyrene (PS). For example, vacuum molding, preferably an epoxy resin is used. Also recycled or bio-based materials can be used.

Alternatively, or additionally, the second substrate may comprise a printed encapsulation layer. For example, in some embodiments, the device comprises a flexible circuit layer, and the printed encapsulation layer is printed on a first and/or second side of the flexible circuit layer. In other or further embodiments, the device further comprises a protective layer disposed between the second substrate and the at least one delamination layer, wherein the protective layer is arranged for protecting the circuit layer during deformation or heating. Advantageously, the protective layer can function as a thermal and/or mechanical buffer layer between the second substrate and the circuit layer during the deformation process. This may, e.g., help to protect circuit parts, such as an OLED, during deformation and/or heating.

In some embodiments, the second substrate comprises a fluid inlet formed by an open passage extending from an exterior of the second substrate to the at least one delamination layer inside the device. The injected fluid can dissolve or disintegrate the at least one delamination layer. In this way the circuit layer may be released from at least one, preferably both, of the first and second substrate for recycling one or more of its circuit parts, e.g. without applying mechanical delamination forces for separating the layer and components. In this way, the risk of damaging the circuit parts during the recycling process can be reduced. Furthermore, the substrates and/or encapsulation layer may be isolated from each other for separate recycling, e.g. without applying mechanical delamination forces.

In some embodiments, the electronic device further comprises a reversible adhesive at the light absorbing areas, preferably between the first substrate and the light absorbing areas. Beneficially, the reversible adhesive can be employed to accommodate reapplying the second substrate to the first substrate after optional repairing. The reversible adhesive can e.g. be thermally sensitive, such as a Diels-Alder reversible adhesive, of which the adhesive properties are time-dependent. For example, debonding may occur within a time frame < 1 s from the application of instantaneous heat via high power photonic flashes, while re-gluing by conventional heating may be enabled within a time frame >> 1 minute. Such a Diels-Alder reversible adhesive may not be negatively affected by short flashes from a photonic debonding process as it can have a substantially transparent composition. Also, such an adhesive may substantially hold its shape under photonic flashing, thereby allowing re-gluing by conventional application of heat. Instead of Diels-Alder reversible adhesives, other reversible adhesives can be envisioned that allow re-application of the second substrate to the first substrate. The reversible adhesive may be embedded within the design, e.g. inside one or more recesses or grooves in the first or second substrate, to avoid having to apply an adhesive to a 3D shaped structure. Embedding the reversible adhesive in the design may also avoid applying too much adhesive material, by ensuring that an optimal amount is added while excessive amounts are compensated, e.g. removed or withdrawn from adjacent areas.

In some embodiments, the circuit layer is separable from the second substrate and/or encapsulation layer by the delamination layer material being dissolvable and/or disintegrable by a solvent, preferably a non-toxic solvent. Preferably, the solubility is more than 0.1 gram per 100 milliliter of solvent, more preferably ≥1 g / 100 mL, ≥10 g / 100 mL, ≥100 g / 100mL, or without limit. The higher the solubility, the more easily the delamination layer material may be dissolved. The process of dissolving the delamination layer may include a step of reducing the first adhesive strength of the delamination layer to the circuit layer, e.g. by applying heat.

Incidentally, in case the delamination layer comprises a relatively weak adhesive or if most of the surface is devoid of the delamination layer, the relatively weak adhesive bond between the circuit layer and the first and/or second substrate fails more easily without performing a process of dissolving the delamination layer.

Preferably, the at least one delamination layer is dissolvable in a biodegradable and/or non-toxic solvent, e.g. low impact solvents such as water or alcohol. Accordingly the interconnections between the circuit layer and the second substrate and/or the first substrate can be broken by a solvent, while minimizing the ecological footprint during the recycling process. The circuit layer may be released from at least one, preferably both, of the substrates for recycling one or more of its circuit parts. Furthermore, the substrate and encapsulation layers may be isolated from each other for separate recycling.

In some embodiments, the solubility of the delamination layer material in a respective low impact solvent such as alcohol or water is higher than the solubility of the first or second substrate material and/or encapsulant material in the respective solvent, e.g. higher by at least a factor ten, fifty, hundred or more. Most preferably, the first or second substrate material and/or encapsulant material is essentially insoluble in the respective solvent, e.g. insoluble in alcohol or water. The more insoluble the first or second substrate material and/or encapsulant material, the better may the structural integrity be maintained during normal use.

In other or further embodiments, the circuit layer is separable from the second substrate and/or encapsulation layer by the delamination layer material having a relatively low melting point, liquification/softening temperature and/or glass transition temperature compared to the second substrate material and/or encapsulant material, e.g. at least ten, twenty, fifty, or hundred degrees Celsius lower and/or in absolute sense preferably less than 200 °C, or even less than 150 °C. For example, the second substrate material may have relatively high melting point, liquification/softening temperature and/or glass transition temperature so it does not soften during normal use, e.g. staying solid at least up to hundred degrees Celsius, preferably at least up to 200 °C or 250 °C.

In other or further embodiments, the circuit layer is separable from the first substrate and/or second substrate by the delamination layers and/or their materials having a relatively weak adhesive force per surface area to each other and/or to the first substrate and/or to the second substrate and/or to the substrate material of the optional electronics substrate -at least compared to a relatively strong adhesive force between the first substrate and second substrate, e.g. lower by at least a factor two, three, five, ten or more. Also other types of separation can be envisaged. The first adhesive strength of the delamination layer may be weaker than is required for a full area adhesive, since the majority of the structural strength of the device is defined by the second adhesive strength between the first and second substrate.

In some embodiments, the one or more light absorbing areas are black and the one or more light reflecting areas are white, thereby providing an alignment marker for aligning the first substrate with respect to the circuit layer and/or the second substrate. For example, the thus provided alignment marker of one or more black and white areas can form a Quick Response (QR) code, in which the one or more black and white areas are arranged in a two dimensional matrix pattern, or barcode, which provides a machine-readable optical label that can comprise information about the first substrate or other part of the device. Such information can e.g. include an identifier, a locator, or a tracker, such as a part, serial or batch number, mounting aids or fiducials, or a reference to process, recycling or assembly instructions. Alternatively, the alignment marker of one or more black and white areas may form another type of optical label, such as a line pattern or one or more fiducial markers, to present information in a computer readable fashion. In some embodiments, the electronic device comprises a further graphic layer at the second side. The further graphic layer may form a window or other pattern depending on the functionality of the device. For example, the window may allow passage of light from the circuit layer. In this case, the second side may form a front side of the device. Of course the directionality may also be reversed and a further graphic layer can be provided on the first substrate. Further graphic layers can also be provided on both the first and second substrates. For example, the further graphic layer on the backside may cover the whole device.

In some embodiments, the electronic device comprises a further circuit layer comprising further circuit parts at the second side, and at least one delamination layer covering a side of the further circuit layer facing the first substrate, wherein the further graphic layer is disposed at the second side between the further circuit layer and the second substrate. The further graphic layer may comprise a pattern of one or more light reflecting areas and one or more light absorbing areas. The one or more light reflecting areas can be arranged to cover the further circuit parts at the second side, wherein the one or more light absorbing areas are arranged at areas without the further circuit parts and without the at least one delamination layer, forming an adhesive connection between the first substrate and the second substrate with a second adhesive strength higher than the first adhesive strength of the at least one delamination layer. The one or more light absorbing areas may be configured to delaminate under the influence of light transmitted through the second substrate and absorbed by the one or more light absorbing areas, while the one or more light reflecting areas are configured to reflect said light. Thus, by applying a further graphic layer comprising a pattern of one or more light absorbing and light reflecting areas, a recyclable electronic device with multiple layers of circuit parts is provided.

In yet other or further embodiments, the second substrate comprises a hot melt encapsulant or other printable encapsulant. Accordingly, the resulting device may be a flexible device and/or comprise flexible areas. For example, the encapsulation layer may comprise a relatively thin layer, preferably a flexible hot melt layer and/or printed layer and/or other material that stays flexible after solidifying.

Other aspects of the present disclosure relate to a method for manufacturing an electronic device. The method comprises providing a stack comprising a first substrate disposed at a first side of the stack, a circuit layer comprising circuit parts, and a second substrate to a second side of the stack, opposite the first side, wherein the second substrate is shaped to encapsulate the circuit layer between the applied second substrate and the first substrate. The method further comprise the step of applying a delamination layer between the circuit layer and the second substrate, wherein the delamination layer is configured to separate the circuit parts from the second substrate, wherein the delamination layer comprises a material with a first adhesive strength, and the step of applying a graphic layer between the circuit layer and the first substrate, wherein the graphic layer comprises a pattern of one or more light reflecting areas and one or more light absorbing areas. The one or more light absorbing areas are arranged at areas without the circuit parts and without the at least one delamination layer forming an adhesive connection between the first substrate and the second substrate with a second adhesive strength higher than the first adhesive strength of the at least one delamination layer. The one or more light absorbing areas are configured to delaminate under the influence of light transmitted through the first substrate and absorbed by the one or more light absorbing areas, while the one or more light reflecting areas are configured to reflect said light.

Accordingly a recyclable electronic device can be manufactured, e.g. an electronic device as described herein, with improved reliability and durability while its recyclability is maintained.

Other aspects of the present disclosure relate to a method for recycling an electronic device. The method comprises providing the electronic device described herein, and directing light toward the first side of the stack, thereby delaminating the one or more light absorbing areas under the influence of the light transmitted through the first substrate and absorbed by the one or more light absorbing areas, while the one or more light reflecting areas are configured to reflect said light.

In some embodiments, after the step of directing the light, the method comprises the step of using the rest of the delamination layers to separate the first substrate and the second substrate, e.g. mechanically, preferably exposing the circuit layer. For example, a peel force can be applied substantially normal to the first and/or second side of the device. Alternatively, or additionally, a shear force can be applied to impose a relate displacement between the first and second substrate in plane of the circuit layer. In this way, the first and second substrate, as well as the circuit layer, can be mechanically separated from each other.

In other or further embodiments, after the step of directing light, the method comprises the step of injecting a fluid into a fluid inlet through the second substrate to the delamination layer in between the second substrate and the circuit layer, wherein the injected fluid forces the second substrate and the circuit layer apart by a pressure of the injected fluid, and/or the injected fluid dissolves or disintegrates the delamination layer. Preferably, the fluid is heated to further facilitate dissolving, melting and/or other disintegration of the delamination layer(s). For example, the injected fluid has a temperature of more than 50 °C, or even more than 100 °C. For example, hot water and/or steam can be injected. Also other liquids and/or gasses can be injected.

In yet other or further embodiments, the method further comprises the step of irradiating and/or heating the electronic device. For example, the radiation and/or heat causes melting or disintegration of the one or more delamination layers facilitating separation of the circuit layer from the first and second substrate and/or the encapsulation layer. For example, the one or more delamination layers may comprise a material that disintegrates under influence of microwave, ultraviolet, visible or (infra-red) IR radiation. Also other types of delamination triggering can be envisaged, e.g. embedding a photoacid and/or gas generating material in the one or more delamination layers. For example, gas generated in the delamination layers e.g. triggered by light and/or chemical trigger.

Other aspects of the present disclosure relate to an apparatus for recycling the electronic device described herein. The apparatus comprises a photonic debonding tool, comprising a light source arranged for directing light to the first side of the electronic device, for thereby delaminating the one or more light absorbing areas under the influence of the light transmitted through the first substrate and absorbed by the one or more light absorbing areas, while the one or more light reflecting areas are configured to reflect said light.

In some embodiments, the apparatus further comprises a delamination tool, arranged for injecting a fluid into a fluid inlet through the second substrate to the delamination layer in between the second substrate and the circuit layer, wherein the injected fluid forces the second substrate and the circuit layer apart by a pressure of the injected fluid, and/or the injected fluid dissolves or disintegrates the at least one delamination layer.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A and 1B illustrate an embodiment of an electronic device;
FIGs 2A and 2B illustrate another or further embodiment of the electronic device described herein;
FIGs 3A and 3B illustrate yet another or further embodiment of the electronic device described herein;
FIG 4 illustrates an embodiment of an apparatus for recycling the electronic device described herein.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

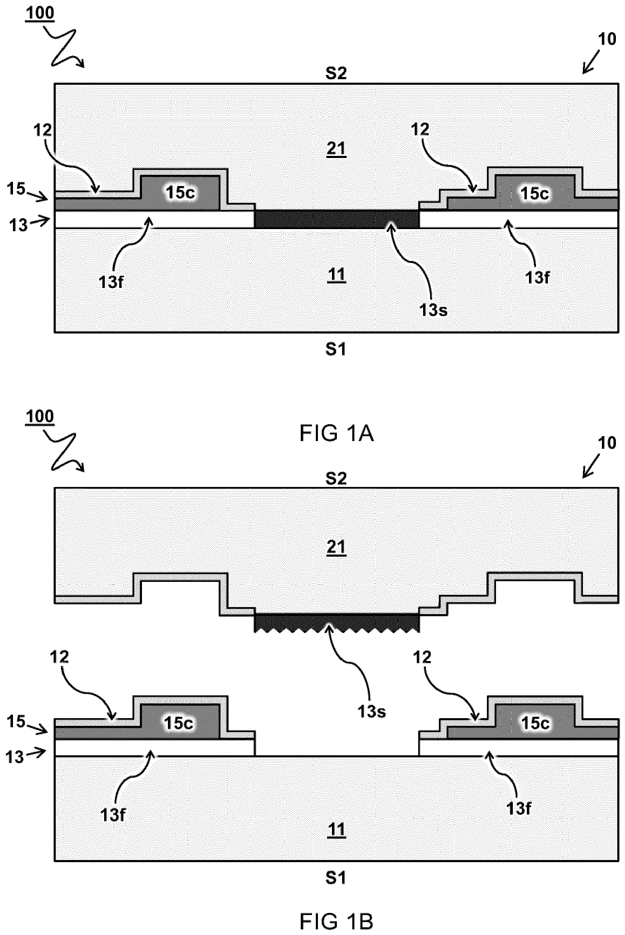

FIGs 1A and 1B illustrate an embodiment of an electronic device 100, in laminated and delaminated states, respectively. The electronic device 100 comprises a stack 10 of a first substrate 11, provided on a first side S1 of the stack 10. In some embodiments, the first substrate 11 is transparent, e.g. allowing light to pass through the first substrate 11. For example, the first substrate 11 is configured to pass at least 50% of the light, preferably at least 80%, more preferably at least 90%, e.g. up to 99%, or more. Said light may be one or more of visible light, ultra-violet (UV) light, or infrared (IR) light. For example, in the visible light spectrum, the light can have a wavelength ranging between 200-1100 nanometer, preferably ranging between 300-1000 nanometer, more preferably ranging between 350-900 nanometer. In some embodiments, the first substrate 11 may form a front substrate, so the first side S1 may later form the frontside of the resulting device.

A second substrate 21 is provided on a second side S2 of the stack 10 opposite the first side S1. In other or further embodiments, the second substrate 21 is transparent, e.g. allowing said light to pass through the second substrate 21. In some embodiments, the second substrate 21 may form a backing layer of the resulting device. Alternatively, the first substrate 11 may form a back substrate and/or the second substrate 21 may be at a frontside at the second side S2 of the resulting device. Of course it will be understood that the front or backside designation of the device may depend on the intended use and/or the orientation of the circuit layer 15, e.g. forming part of a user interface which may include lighting, displays, buttons, user access points, et cetera. It can also be envisaged that both sides of the device comprise a user interface, thus forming two front sides; or that neither side of the device is intended as a user interface e.g. forming an internal component or device, so the designation of a front side may be arbitrary.

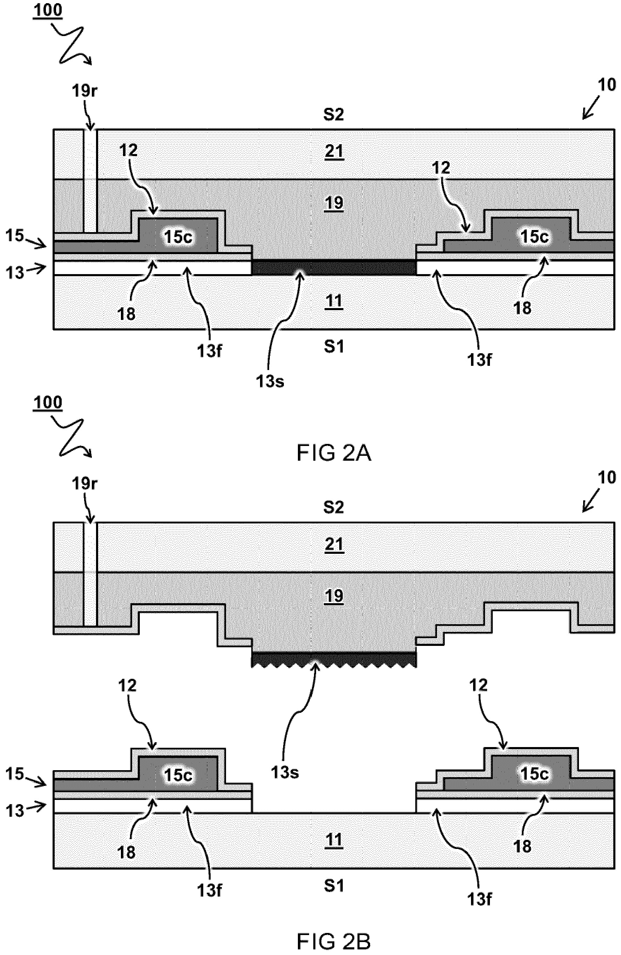

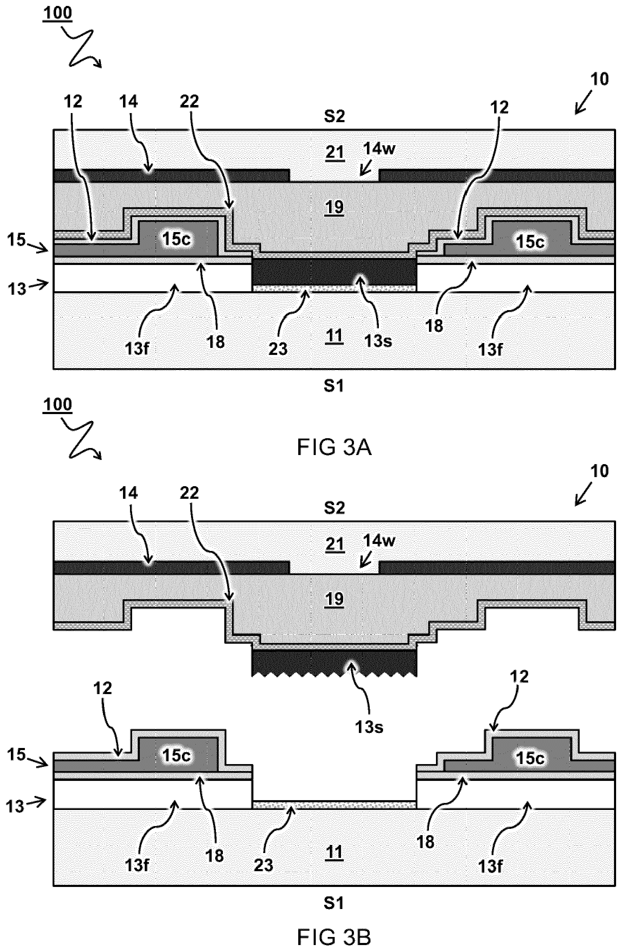

A circuit layer 15 is disposed between the first substrate 11 and the second substrate 21 and comprises circuit parts 15c such as surface mounted devices (SMD) and/or circuit lines connecting the devices. As illustrated in FIG 1A, the second substrate 21 is shaped to encapsulate the circuit layer 15 between the second substrate 21 and the first substrate 11. Typically, the circuit layer 15 is formed by an electric circuit, e.g. including circuit lines, with one, two, three, or more circuit parts 15c such as SMD. Preferably, one or more circuit parts 15c, e.g. SMD, are covered by glob-topping (not shown). In some embodiments, the stack 10 comprises at least one delamination layer 12, covering a side of the circuit layer 15 facing the second substrate 21. In one embodiment, glob-topping is applied after to applying the delamination layer 12, e.g. between the circuit parts 15c and the delamination layer 12. This may prevent damage to the circuit parts when delaminating the layers. In some embodiments, the circuit layer 15 is formed, e.g. by deposition, printing, etcetera, on top of a layer below, e.g. on top of the graphic layer 13 (which may be on top of the first substrate 11), such as shown in the FIG 1, and/or on top of another delamination layer 18 there between, such as shown in FIGs 2 and 3. In other or further embodiments (not shown), the circuit layer 15 may be formed on a separate electronics substrate, which may be embedded between the first and second substrates 11,12 with respective further layers there between. For example, the separate electronics may be manufactured separately and applied on top of layers there below.

Typically, the delamination layers 12 and/or 18 may comprise a material with a first adhesive strength configured to separate the circuit parts 15c from the second substrate 21. In one embodiment, the circuit layer 15 is covered by the at least one delamination layer 12 or embedded between delamination layers (e.g. layers 12, 18). For example, a circuit layer 15 with one or more electronic parts 15c is formed on one or both sides of a flexible substrate that is embedded between delamination layers 12. In one embodiment, the circuit layer 15 comprises an OLED device. Also other or further circuit parts 15c can be arranged on the electronics substrate such as sensors, e.g. a touch sensitive display. This may allow an at least partially pre-fabricated substrate with components to be applied in the stack while allowing separation in a later recycling process.

Delamination is a process wherein a material or object, in this case the stack 10, can be separated into layers. This may also be referred to as debonding. As will be appreciated, applying the at least one delamination layer 12 to a side of the circuit layer 15 facing the second substrate 21 may allow relatively easy separation of the circuit parts 15c from the second substrate 21 and/or first substrate 11 during a later recycling process after the device end of use. Accordingly, electronic components and/or circuit parts 15c can be more easily separated from the second substrate 21 without being stuck to the second substrate 21. This may improve recyclability of the device.

In one embodiment, the separate electronics substrate is made of the same material as the at least one delamination layer 12. So, effectively, a stack of at least two layers of delaminating material may be formed including the separate electronics substrate. This may further facilitate delamination and/or disintegration of the intermediate layers and isolation of the electronics. In another or further embodiment, the separate electronics substrate is made of a different material than the at least one delamination layer 12, e.g. PET, PEN, or any other preferably flexible material.

In some embodiments, the resulting device may be a flexible device and/or comprise flexible areas. For example, the second substrate may comprise an encapsulation layer 19 with a relatively thin layer, preferably a flexible hot melt layer and/or other material that stays flexible after solidifying. In other or further embodiments, the resulting device may be a rigid device and/or comprise rigid areas. For example, the encapsulation layer 19 may comprise a relatively thick layer and/or a thermohardening material, e.g. injection molded material. Also other or further layers in the stack may be either flexible or rigid.

In some embodiments, some or all of the electronics e.g. circuit lines, SMD, et cetera are directly applied onto the stack, e.g. applied on the first substrate 11 and/or the at least one delamination layer 12 which may cover the first substrate 11. In one embodiment, a set of circuit lines and/or electric electronic parts 15c is printed on the stack 10, e.g. first substrate 11 and/or delamination layer 12. In another or further embodiment, the circuit layer 15 is electrically connected to printed circuit lines. In another or further embodiment, the circuit layer 15 can be applied by light induced forward transfer LIFT or other techniques such as pick and place.

In some embodiments, the at least one delamination layer 12 is printed onto the stack, e.g. using screen printing. Alternatively, the at least one delamination layer 12 can be applied by laminating a preformed layer. Also other methods can be used, e.g. spray coating, dispensing, plasma printing, plasma treatment or chemical vapor deposition.

In some embodiments, one or more further delamination layers 18 can be provided as part of the stack 10 to cover a side of the circuit layer 15 facing the first substrate 11, to facilitate separation. In this arrangement, the one or more delamination layers 12, 18 may keep the electronic parts separate from the other layers of the stack 10, e.g. first and second substrate 11, 21 on opposite sides of the circuit layer 15.

In one embodiment, the first adhesive strength of the one or more delamination layers 12, 18 is less than 10 Newton per square centimeter, preferably less than one Newton per square centimeter, more preferably less than 0.5 N/cm^2, most preferably less than 0.1 N/cm^2. Alternatively, e.g. in a peel test, the first adhesive strength of the one or more delamination layers 12, 18 is less than 20 N/cm, for example between 10-20 N/cm or between 5-15 N/cm, more preferably between 3-10 N/cm.

As illustrated, a graphic layer 13 disposed between the circuit layer 15 and the first substrate 11. The graphic layer 13 comprises a pattern of one or more light reflecting areas 13f and one or more light absorbing areas 13s. The one or more light reflecting areas 13f are arranged to cover the circuit parts 15c at the first side S1. The one or more light absorbing areas 13s are arranged at areas without the circuit parts 15c and without the at least one delamination layer 12 (as seen in plan view, from below or above) forming an adhesive connection between the first substrate 11 and the second substrate 21 with a second adhesive strength higher than the first adhesive strength of the at least one delamination layer 12. The one or more light absorbing areas 13s are configured to delaminate under the influence of light transmitted through the first substrate 11 and absorbed by the one or more light absorbing areas 13s (acting as a photonically activated delamination layer), while the one or more light reflecting areas 13f are configured to reflect said light. In general, the graphic layer comprises an electrically non-functional material. In this way, function of the graphic layer is independent from the circuit layer, so that the pattern of one or more light reflecting areas and one or more light absorbing areas can be applied without influencing electrical connections between the circuit parts of the circuit layer. However, in some further or alternative embodiments, additional light-reflective and/or light-absorbent material or elements may be incorporated in the graphic layer.

In another or further embodiment, the second adhesive strength is more than one Newton per square centimeter, preferably more than 10 N/cm^2, or even ≥100 N/cm^2. Alternatively, e.g. in a peel test, such as a 90 or 180 degrees pees test, the second adhesive strength is preferably more than 20 N/cm, more than 30 N/cm, or even more than 40 N/cm. In particular, the second adhesive strength may exceed the structural integrity of the materials/layers, e.g. the layers may be torn when trying to separate them. As will be appreciated, the adhesive area and thickness of the one or more delamination layers 12, 18 and the graphic layer 13 can be adapted to tune the effective ratio between the values of the relatively weak adhesive strength of the one or more delamination layers 12, 18, as such, and the relatively strong strength in the second connection where the delamination layer is absent.

In some embodiments, the pattern of one or more light absorbing areas 13s is complementary to the pattern of one or more light reflecting areas 13f. For example, the graphic layer 13 may have a total area, and the pattern of one or more light absorbing areas 13s may be arranged with respect to the pattern of one or more light reflecting areas 13f for thereby covering the total area of the graphic layer 13. For example, the one or more light absorbing areas 13s and one or more light reflecting areas 13f may be arranged in an alternating pattern, a checkerboard pattern, or an island- and-channel pattern. However, some parts of the total area of the graphic layer may not comprise a light absorbing area 13s or light reflecting are 13f, e.g. in case at said parts there are no circuit parts 15c to be covered and no connection to be established between the first and second substrate 11, 21.

For example, the graphic layer 13 may be illuminated with broadband light emitted from a photonic debonding tool, comprising a light source arranged for directing light at the graphic layer 13 through the first substrate 11 and/or the second substrate 21 to delaminate the first substrate 11 from the second substrate 21. The photonic debonding tool may e.g. be arranged for emitting broadband light 200 nm - 1100 nm towards the graphic layer 13, e.g. with peak radiant intensity as high as 45 kW/cm2, e.g. in one or more pulses of less than a millisecond.

In one embodiment, the first substrate 11 is made of a transparent material that allows said light to pass through. In another or further embodiment, the second substrate 21 is made of a transparent material that allows said light to pass through. For example, the transparent material is configured to pass at least 50% of the light, preferably at least 80%, more preferably at least 90%, e.g. up to 99%, or more. When illuminated through the first or second substrate 11, 21, the one or more light absorbing areas absorb a majority of the light and e.g. convert it to energy and/or heat needed to delaminate the first substrate 11 from the second substrate 21.

Preferably, the graphic layer 13 comprises a material composition that includes adhesive both light absorbing properties as well as adhesive properties, of which material composition the adhesive strength is decreased by the conversion of absorbed light into energy, e.g. heat.

In another or further embodiment, the graphic layer 13 comprises heterogeneous material compositions that are interspersed, e.g. in adjacently stacked intermediate layers, at least one of which material compositions having light absorbing properties, and others having adhesive properties. As such, when the light absorbing material composition converts the absorbed light into heat, the adhesive properties of the adhesive material composition is decreased.

FIGs 2A and 2B illustrate another or further embodiment of the electronic device 100, in laminated and delaminated states, respectively, wherein the second substrate 21 comprises an injection molded encapsulation layer 19. The encapsulation layer 19 can e.g. be applied by injection molding, e.g. using the stack 10 as front part of the mold. In another or further embodiment, the encapsulant material comprises or essentially consists of a resin, preferably an injection moldable resin, e.g. thermoplastic polymer. Also other types of polymers and/or plastics can be used. Also other molding techniques can be used to apply the encapsulant 19, e.g. vacuum molding. In some embodiments, the same material is used as the second substrate 21. This may improve bonding between the encapsulation layer 19 and second substrate 21. Suitable materials may e.g. include polycarbonate (PC), polyamide (PA), polyether ether ketone (PEEK), high-density polyethylene (HDPE), and/ or polyethylene terephthalate (PET). Also other or further materials can be used such as Acrylonitrile Butadiene Styrene (ABS), polyethylene (PE), polypropylene (PP), and/or polystyrene (PS). For example, vacuum molding, preferably an epoxy or polyurethane (PU) resin is used. Also bio-based materials can be used.

Alternatively, or additionally, the encapsulation layer 19 can be applied as a hot melt material or a printed material, e.g. hot melt adhesive or layer and/or substrate. Similar to a molding material, the hot melt material may be temporarily liquified e.g. by elevated temperature and/or pressure to encapsulate the circuit layer 15 between the first and second substrate 11, 21. For example, this may reinforce the connection between the encapsulation layer 19 and second substrate 21 while still allowing delamination during a recycling process.

As illustrated in FIGs 2A and 2B, the second substrate 21 comprises a fluid inlet 19r formed by an open passage extending from an exterior of the second substrate 21 to the one or more delamination layers 12, 18 inside the device, e.g. between inside surfaces of the second substrate 21 and encapsulant layer 19. In one embodiment, the fluid inlet 19r is sealed during use of the device for preventing exposure of the delamination layer 12, 18 to an external surroundings. For example, the fluid inlet 19r is sealed by a sealing material or object, wherein the sealing is removable for implementing a recycling process.

In some embodiments, the fluid inlet 19r is connected to a channel along a surface of the device between the second substrate 21 and encapsulation layer 19 to guide an injected fluid Sr towards different parts of the one or more delamination layers 12, 18. In one embodiment, the channel branches in different paths. In another or further embodiment not shown, multiple fluid inlets are provided to access different parts of the one or more delamination layers 12, 18.

In some embodiments, a fluid, e.g. hot liquid solvent, is injected into the fluid inlet 19r to the one or more delamination layers 12,18 e.g. in between the substrate and encapsulation layer. The injected fluid can dissolve or disintegrate the one or more delamination layers 12, 18. In this way the circuit layer 15 may be released from at least one, preferably both, of the first and second substrate 11, 21 for recycling one or more of its circuit parts 15c. Furthermore, the substrates 11, 21 and encapsulation layer 19 may be isolated from each other for separate recycling.

FIGs 3A and 3B illustrate yet another or further embodiment of the electronic device 100, in laminated and delaminated states, respectively. A protective layer 22 is disposed between the second substrate 21 and the at least one delamination layer 12. Accordingly, the circuit layer 15 is protected during deformation or heating wherein the protective layer 18. Advantageously, the protective layer 22 can function as a thermal and/or mechanical buffer layer between the second substrate 21 and the circuit layer 15 during the deformation process. This may, e.g., help to protect circuit parts 15c, such as an OLED, during deformation and/or heating.

As illustrated, a reversible adhesive 23, such as a Diels-Alder adhesive, is provided at the light absorbing areas 13s, preferably between the first substrate 11 and the light absorbing areas 13s. Alternatively, or additionally, a reversible adhesive 23 may be provided between the light absorbing areas 13s and the second substrate 21 or encapsulation layer 19.

FIGS 3A and 3B also illustrate a further graphic layer 14 at the second substrate 21. In one embodiment, an opaque further graphic layer 14 covers a second side S2 view of at least some of the electronics. In another or further embodiment, a transparent or translucent window 14w in the further graphic layer 14 may allow light to pass through from one or more lighting devices in the circuit layer 15, e.g. display or other lighting. In one embodiment, the further graphic layer 14 is on the first side S1 of the second substrate 21. So the delamination layer 12 and/or the circuit layer 15 may be applied onto the further graphic layer 14 of the second substrate 21. Alternatively, or in addition, the further graphic layer 14 can also be applied to the second side S2, or the further graphic layer 14 can be embedded in the second substrate 21.

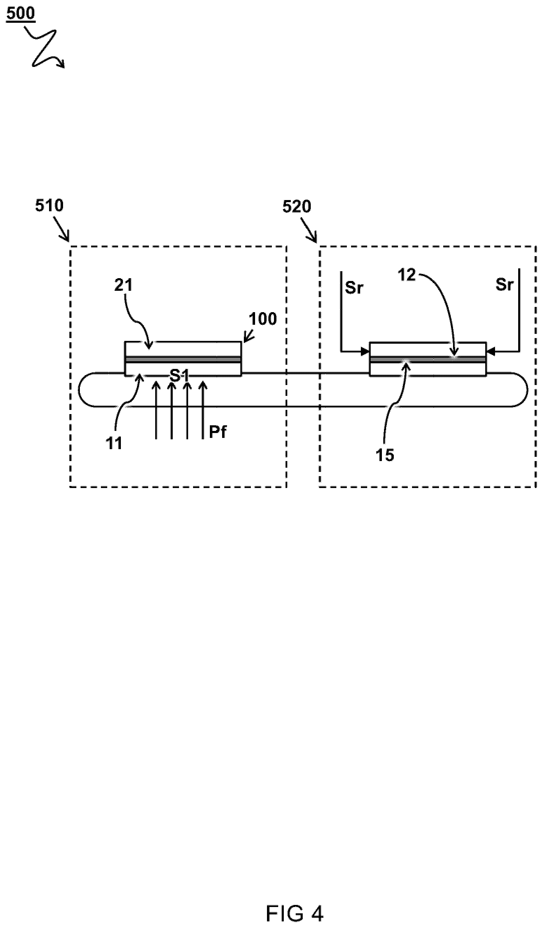

FIG 4 illustrates an embodiment of an apparatus 500 for recycling the electronic device 100 described herein. The apparatus 500 comprises a photonic debonding tool 510, comprising a light source arranged for directing light Pf to the first side S1 of the electronic device 100, for thereby delaminating the one or more light absorbing areas 13s under the influence of the light transmitted through the first substrate 11 and absorbed by the one or more light absorbing areas 13s, while the one or more light reflecting areas 13f are configured to reflect said light.

The apparatus 500 may further comprise a delamination tool 520, arranged for injecting a fluid Sr into a fluid inlet 19r through the second substrate 21 to the delamination layer 12 in between the second substrate 21 and the circuit layer 15, wherein the injected fluid Sr forces the second substrate 21 and the circuit layer 15 apart by a pressure of the injected fluid Sr, and/or the injected fluid Sr dissolves or disintegrates the at least one delamination layer 12.

Advantageously, as described in the present disclosure, after delamination of the first and second substrate 11, 21, the graphic layer 13 still allows relatively easy separation of the electronic parts 15c from the first substrate 11 and the second substrate 21 and/or encapsulation layer 19 during a later recycling process after the device end of use. Accordingly, the circuit parts 15c may be easily exposed for removal from the first substrate 11. While the figures show the circuit layer 15 being manufactured on a separate substrate which is provided on the first substrate 11, the circuit layer 15 can also be directly manufactured on the graphic layer 13 without requiring a separate substrate.

Accordingly, the circuit parts 15c may be exposed for facilitating removal, e.g. from the second substrate 21 or encapsulation layer 19. In any case, it will be appreciated that the features described with reference to the preceding figures such as light absorbing areas and light reflecting areas et cetera, may be applied mutatis mutandis while omitting either of the one or more delamination layers 12, 18 to achieve at least some of the advantages of easy separation and/or at least partial exposure of the circuit layer 15, thus allowing a more efficient recycling process.

While the present figures illustrate the first substrate 11 completely separating from the second substrate 21, this may not be necessary to remove the circuit layer 15 there between. For example, some or all of the circuit parts 15c and other electronic components may be flushed with from the device, e.g. via the fluid inlet 19r and/or fluid outlet not shown.

For the purpose of clarity and a concise description, features are described herein as part of the same or separate embodiments, however, it will be appreciated that the scope of the invention may include embodiments having combinations of all or some of the features described. For example, while embodiments were shown for an electronic device and an apparatus for recycling the electronic device, also alternative ways may be envisaged by those skilled in the art having the benefit of the present disclosure for achieving a similar function and result. E.g. FIGs 1-3 may be combined or split up into one or more alternative components. The various elements of the embodiments as discussed and shown offer certain advantages, such as improved reliability and durability while maintaining recyclability. Of course, it is to be appreciated that any one of the above embodiments or processes may be combined with one or more other embodiments or processes to provide even further improvements in finding and matching designs and advantages. It is appreciated that this disclosure offers particular advantages to recycling of electronic devices, and in general can be applied for any application wherein durability and reliability of the device is key.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. An electronic device (100) comprising a stack (10) comprising:
a first substrate (11), provided on a first side (S1) of the stack (10);
a second substrate (21), provided on a second side (S2) of the stack (10) opposite the first side (S1);
a circuit layer (15) comprising circuit parts (15c) disposed between the first substrate (11) and the second substrate (21), wherein the second substrate (21) is shaped to encapsulate the circuit layer (15) between the second substrate (21) and the first substrate (11);
at least one delamination layer (12) covering a side of the circuit layer (15) facing the second substrate (21) and configured to separate the circuit parts (15c) from the second substrate (21), wherein the at least one delamination layer (12) forms an adhesive connection between the circuit layer (15) and the second substrate (21) with a first adhesive strength; and
a graphic layer (13) disposed between the circuit layer (15) and the first substrate (11), wherein the graphic layer (13) comprises a pattern of one or more light reflecting areas (13f) and one or more light absorbing areas (13s);
wherein the one or more light reflecting areas (13f) are arranged to cover the circuit parts (15c) at the first side (S1),
wherein the one or more light absorbing areas (13s) are arranged at areas without the circuit parts (15c) and without the at least one delamination layer (12), forming an adhesive connection between the first substrate (11) and the second substrate (21) with a second adhesive strength higher than the first adhesive strength of the at least one delamination layer (12),
wherein the one or more light absorbing areas (13s) are configured to delaminate under the influence of light transmitted through the first substrate (11) and absorbed by the one or more light absorbing areas (13s), while the one or more light reflecting areas (13f) are configured to reflect said light.

2. The electronic device (100) according to claim 1, wherein the second substrate (21) comprises an injection molded encapsulation layer (19).

3. The electronic device (100) according to any preceding claim, further comprising a protective layer (22) disposed between the second substrate (21) and the at least one delamination layer (12), wherein the protective layer (18) is arranged for protecting the circuit layer (15) during deformation or heating.

4. The electronic device (100) according to any preceding claim, wherein the second substrate (21) comprises a fluid inlet (19r) formed by an open passage extending from an exterior of the second substrate (21) to the at least one delamination layer (12) inside the device.

5. The electronic device (100) according to any preceding claim, further comprising a reversible adhesive (23) at the light absorbing areas (13s), preferably between the first substrate (11) and the light absorbing areas (13s).

6. The electronic device (100) according to any preceding claim, wherein the one or more light absorbing areas (13s) are black and wherein the one or more light reflecting areas (13f) are white, thereby providing an alignment marker for aligning the first substrate (11) with respect to the circuit layer (15) and/or the second substrate (21).

7. The electronic device (100) according to any preceding claim, comprising a further graphic layer (14) at the second side (S2).

8. The electronic device (100) according to any preceding claim, wherein the second substrate (21) comprises a hot melt encapsulant (19) and/or a printed encapsulant.

9. A method for manufacturing an electronic device, the method comprising:
providing a stack (10) comprising
a first substrate (11) disposed at a first side (S1) of the stack (10),
a circuit layer (15) comprising circuit parts (15c), and
a second substrate (21) to a second side (S2) of the stack (10), opposite the first side (S1), wherein the second substrate (21) is shaped to encapsulate the circuit layer (15) between the applied second substrate (21) and the first substrate (11);
applying a delamination layer (12) between the circuit layer (15) and the second substrate (21), wherein the delamination layer (12) is configured to separate the circuit parts (15c) from the second substrate (21), wherein the delamination layer (12) comprises a material with a first adhesive strength; and
applying a graphic layer (13) between the circuit layer (15) and the first substrate (11), wherein the graphic layer (13) comprises a pattern of one or more light reflecting areas (13f) and one or more light absorbing areas (13s):
wherein the one or more light absorbing areas (13s) are arranged at areas without the circuit parts (15c) and without the at least one delamination layer (12) forming an adhesive connection between the first substrate (11) and the second substrate (21) with a second adhesive strength higher than the first adhesive strength of the at least one delamination layer (12),
wherein the one or more light absorbing areas (13s) are configured to delaminate under the influence of light transmitted through the first substrate (11) and absorbed by the one or more light absorbing areas (13s), while the one or more light reflecting areas (13f) are configured to reflect said light.

10. A method for recycling an electronic device, the method comprising:
providing the electronic device (100) according to any of claims 1-9;
directing light toward the first side (S1) of the stack (10), thereby delaminating the one or more light absorbing areas (13s) under the influence of the light transmitted through the first substrate (11) and absorbed by the one or more light absorbing areas (13s), while the one or more light reflecting areas (13f) are configured to reflect said light.

11. The method according to claim 10, wherein, after the step of directing light, the method comprises the step of injecting a fluid (Sr) into a fluid inlet (19r) through the second substrate (21) to the delamination layer (12) in between the second substrate (21) and the circuit layer (15), wherein the injected fluid (Sr) forces the second substrate (21) and the circuit layer (15) apart by a pressure of the injected fluid (Sr), and/or the injected fluid (Sr) dissolves or disintegrates the delamination layer (12).

12. The method according to claim 10 or 11, further comprising the step of irradiating and/or heating the electronic device (100).

13. An apparatus (500) for recycling the electronic device (100) according to any of claims 1-9, the apparatus comprising:
a photonic debonding tool (510), comprising a light source arranged for directing light (Pf) to the first side (S1) of the electronic device (100), for thereby delaminating the one or more light absorbing areas (13s) under the influence of the light transmitted through the first substrate (11) and absorbed by the one or more light absorbing areas (13s), while the one or more light reflecting areas (13f) are configured to reflect said light.

14. The apparatus (500) according to claim 13, further comprising:
a delamination tool (520), arranged for injecting a fluid (Sr) into a fluid inlet (19r) through the second substrate (21) to the delamination layer (12) in between the second substrate (21) and the circuit layer (15), wherein the injected fluid (Sr) forces the second substrate (21) and the circuit layer (15) apart by a pressure of the injected fluid (Sr), and/or the injected fluid (Sr) dissolves or disintegrates the at least one delamination layer (12).
